# NEW EUROPEAN PATENT SPECIFICATION

(11) **EP 0 249 139 B2**
(45) Date of publication and mention of the opposition decision: **11.03.1998**
(45) Mention of the grant of the patent: 27.07.1994
(21) Application number: 87108037.0
(22) Date of filing: 03.06.1987
(51) Int. Cl.: G03F 7/004, G03F 7/039

(54) **Resist compositions and use**
Lackzusammensetzung und -anwendung
Composition formant réserve et utilisation

(30) Priority: 13.06.1986 US 873914
(43) Date of publication of application: 16.12.1987
(73) Proprietor: MicroSi, Inc. (a Delaware corporation), Phoenix Arizona 85044 (US)
(72) Inventor: Crivello, James Vincent, Clifton Park New York 12065 (US); O'Brien, Michael Joseph, Albany New York 12203 (US); Lee, Julia Lam, Schenectady New York 12309 (US)
(74) Representative: Watkins, David

(56) References cited:
- EP-A- 102 450
- EP-A- 0 146 411
- DE-A- 2 306 248
- JP-A- 603 625
- JP-A- 6 052 845
- JP-A- 6 184 642
- JP-A-46 037 549
- US-A- 4 689 288
- JOURNAL OF IMAGING TECHNOLOGY, vol. 11, no. 4, August 1985, pages 146-157, Society of Photographic Scientist and Engineers, Springvield, Virginia, US; S.P. PAPPAS: "Photogeneration of acid: Part 6 - a review of basic principles for resist imaging applications"
- J. Electrochem. Soc., Solid State Science and Technology, vol. 133, nr. 1, January 1986, pages 181-187, J.M.J. Fréchet et al.: "Approaches to the Disign of Radiation-Sensitive Polymeric Imaging Systems with Improved Sensitivity and Resolution"
- Journal of Imaging Science, Vol. 30, Nr. 2, March/April 1986, Jean M.J. Fréchet et al.: "New Approach to Imaging Systems Incorporating Chemical Amplification: Synthesis and Preliminary Evaluation of Novel Resists Based on Tertiary Copolycarbonates", pages 59-64

## Description

Prior to the present invention as shown by L.F. Thompson et al, Introduction to Microlithography, ACS Symposium Series 219, American Chemical Society, 1983, page 111, novolak-based positive resists based on dissolution inhibition, generally utilize substituted 1,2-diazonaphthoquinones as dissolution inhibitors to render a novolac resin insoluble to development by dilute aqueous base. Upon irradiation, the diazonaphthoquinone undergoes rearrangement and those portions of the resist which have received irradiation by image-wise exposure are rendered soluble to dilute aqueous base. While these photoresists are widely used, they are generally limited to the near UV above 366 nm based on the absorbtion characteristics of the diazonaphthoquinone.

As taught by Ito et al, U.S. Patent No. 4,491,628, positive and negative working resist compositions are provided which can be used in the deep UV region (200-300 nm), as a result of employing diaryliodonium salts, or triarylsulfonium salts as photoinitiators. These photoinitiators are used with vinylic polymer containing recurrent labile pendant groups. The vinylic polymers undergo acidolysis to produce products which are very different in solubility from their precursors.

DE-A-2306248 discloses resist compositions comprising water insoluble organic compounds having acid labile pendant groups and light decomposable acid generator. A base-soluble resin is used as a binder.

Journal of Imaging Technology 11(1985) 4, 146-157 discloses similar compositions discloses novolak resins together with onium salts.

Although effective results can be achieved with the resist compositions of Ito et al, the vinylic polymers and their acid labile substituted monomeric precursors are not commercially available. In addition, the performance of the resulting photoresist is sometimes impaired due to excessive crosslinking resulting from the use of aryl onium salts upon exposure of the photoinitiator under normal operating conditions. Improved results can sometimes be achieved by incorporating stabilizers into the photoresist composition.

The present invention is based on our discovery that photoresist compositions sensitive to electron beam, X-ray and UV over the range of 600 to 200 nm can be made using commercially available polymer as the base resin. The photoresist can be converted from the insoluble to soluble state by the use of commercially available polymers in combination with a dissolution inhibitor having chemically combined acid labile groups, as defined hereinafter, and an aryl onium salt. Although the photoresist dissolution mechanism is not completely understood, it is believed that a chemical amplification effect is achieved upon the generation of acid from the irradiated aryl onium salt. The transformation of the dissolution inhibitor to the soluble state is effected by the acidolysis of the acid labile groups which solubilizes exposed photoresist areas.

There is provided by the present invention a resist composition comprising by weight
(A) 100 parts of organic solvent, and
(B) from 5 to 85 parts of solids admixed with (A) comprising by weight
   (1) 100 parts of a water or aqueous base soluble organic polymer having an average MW of from 200 to 20,000;
   (2) 5 to 100 parts of an acid labile group substituted simple compound which is a dissolution inhibitor for (1), which is insoluble in water or aqueous base, has a boiling point of at least 100°C, and is selected from tertiary butyl esters, aryl tertiary butyl ethers, aryl tertiary butyl carbonates, 3-cyclohexenyl benzoate, and 3,6-bis(benzoyloxy)cyclohexene, and
   (3) an effective amount of an aryl onium salt.

The compositions are useful as water or aqueous base soluble resists. Some of the water or aqueous base soluble organic polymers which can be utilized in the practice of the present invention to make the above described resist compositions, referred to hereinafter as "polymer" are, for example: phenol novolac resins, cresol novolac resins, chlorophenol novolac resins, melamine-formaldehyde resins, water soluble starch, and cellulose polymers, e.g. carboxymethylhydroxyethyl cellulose, propoxylated celluloses, polyacrylamide, poly-2-hydroxyethylmethacrylate, polymethylvinyl ether, polyethylene oxide, copolymers of 4-hydroxyphenylmaleimide with a member selected from styrene, stilbene, vinyl ethers, and 4-hydroxy styrene, and polymers such as poly-4-vinylphenol, poly-4-hydroxy-α-methylstyrene, polyacryl acrylic acid, and polymethacrylic acid.

Among the acid labile group substituted simple compounds, or dissolution inhibitors referred to hereinafter as "inhibitor" which can be utilized in the practice of the present invention to make the water or aqueous base soluble resists are, for example:

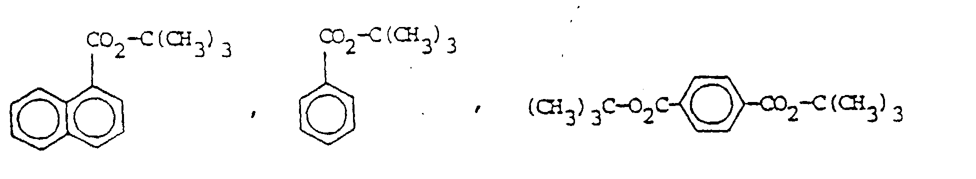

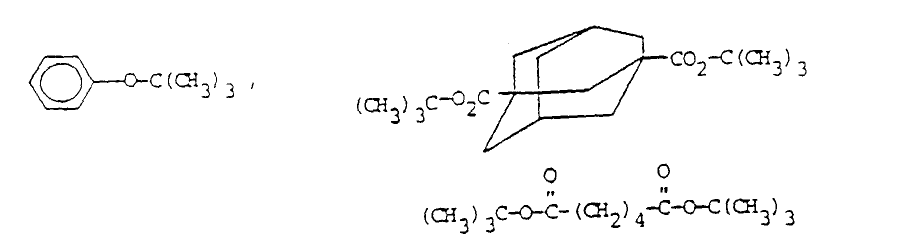

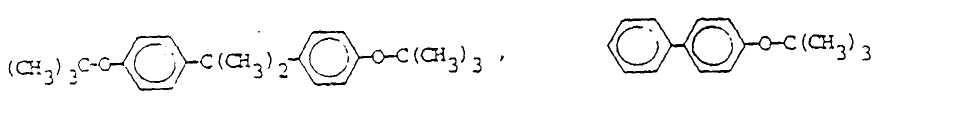

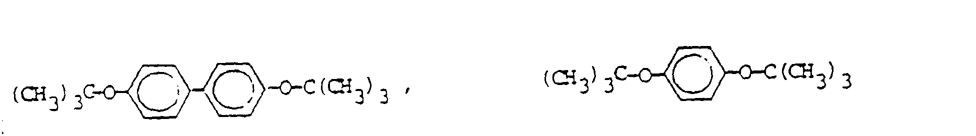

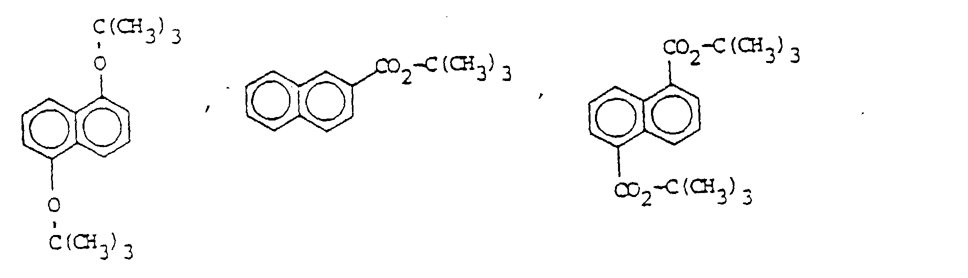

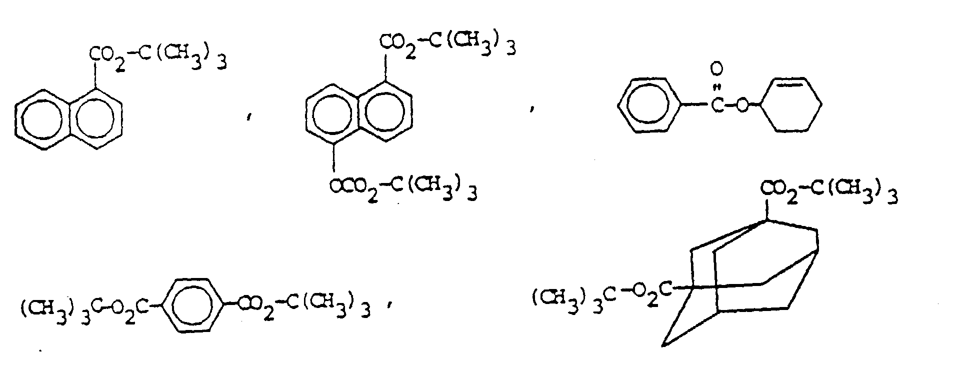

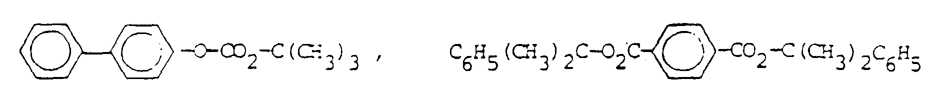

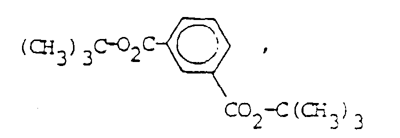

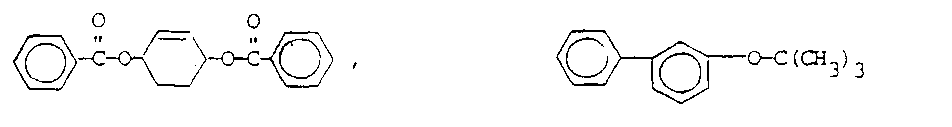

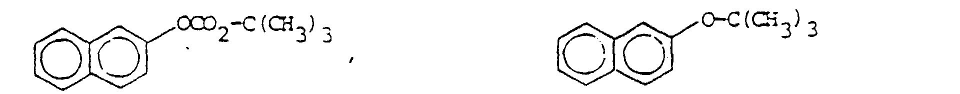

Preferably, the inhibitors of the present invention have a molecular weight of less than about 1000. They have acid labile pendant groups which are preferably tert-butyl esters of carboxylic acid, and tert-butyl carbonates of phenols. In addition, these acid labile groups can be trityl, benzyl, benzhydryl as well as other modifications illustrated in the inhibitors above. Radiation decomposable indicators which can be utilized in the practice of the present invention to generate acid upon exposure referred to hereinafter as the "initiator" are, for example:-
Triarylsulfonium salts, diarylchloronium salts, diarylbromonium salts, triarylselenonium salts, thiopyrylium salts, xanthylium salts, imidazolium salts, dialkylphenacylsulfonium salts, dialkylhydroxyphenylsulfonium salts, ferrocenium salts, diazonium salts, triarylsulfoxonium salts, diaryliodoxonium salts, phenacyltriarylphosphonium salts, phenacyltrialkyl-ammonium salts, phenacylpyridinium salts. Further examples are shown by H.-J. Timpe and H. Baumann, Adhesion 9, 9 (1984) and Crivello patents U.S. 4,058,400 4,058,401; 4,069,055; and 4,151,175; assigned to the same assignee as the present invention and incorporated herein by reference.

The following constitute some additional examples of onium salts:

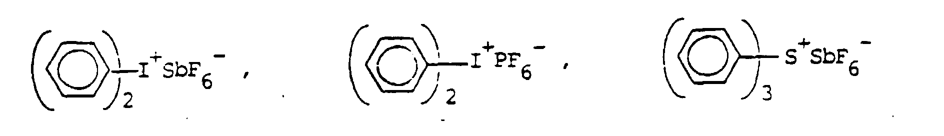

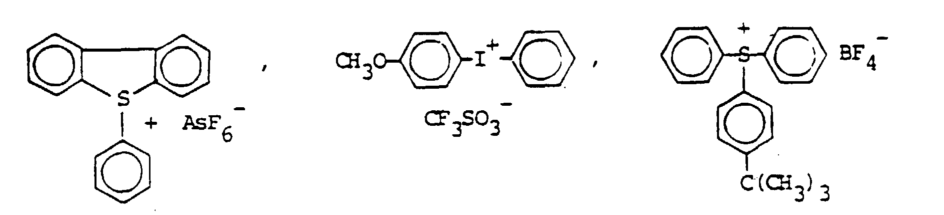

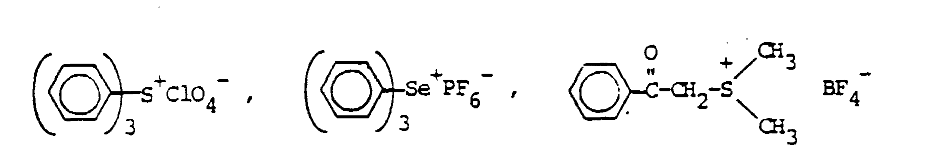

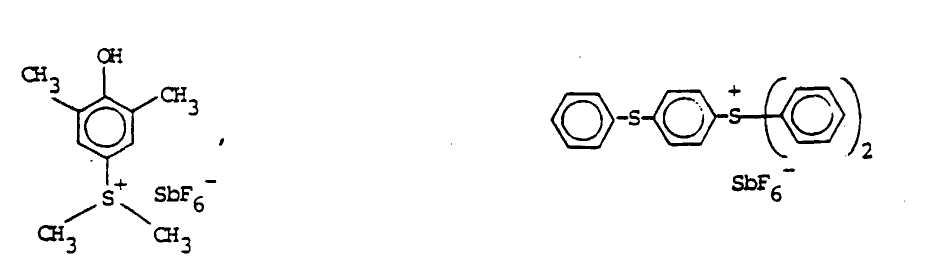

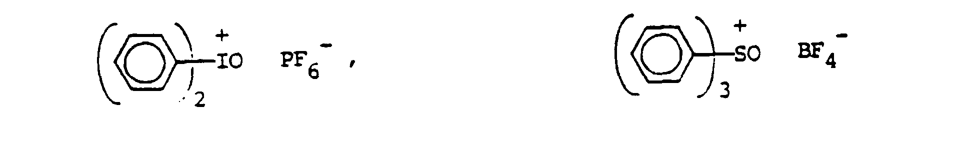

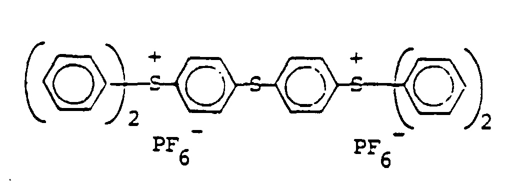

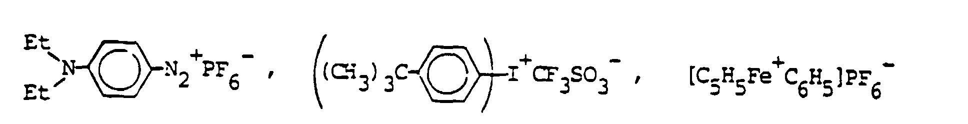

The compositions can be made by blending organic solvent, polymer, inhibitor, and the irradiation decomposable initiator.

In forming the resist composition, the order of addition of the various ingredients is not critical. It has been found that effective results can be achieved if there is utilized from about 5 to about 100 parts of inhibitor and 0.5 part to about 25 parts of initiator, per hundred parts of the polymer. Preferably, there can be used from 5 to 70 parts of inhibitor, per hundred parts of polymer and 1 to 20 parts of initiator, per hundred parts of polymer.

There are included in the term organic solvent which hereinafter means an organic solvent or mixture of organic solvents, which can be utilized in the practice of the present invention to make the resist composition, solvents such as 1,2-dimethoxy ethane, di(2-methoxy ethyl)ether, 1-methoxy-2-propyl acetate, chlorobenzene, 1,1,2,2-tetrachloroethane, 1-methoxy-2-ethyl acetate, dioxane, methylisobutyl ketone, cyclohexanone, n-butanol, ethylene glycol, propylene gycol, amylacetate, and butylacetate.

There is further provided by the present invention, a method for making a patterned resist on a substrate, which comprises:
(1) treating, which means spin coating, spraying, solution casting or dip coating, the substrate with the resist composition of the present invention to produce a resist-substrate composite,
(2) baking the resist-substrate composite to a temperature in the range of from about 35°C to 180°C,
(3) irradiating the applied resist in a patterned manner,
(4) heating the irradiated resist to a temperature in the range of from about 35°C to 185°C, and
(5) developing the irradiated resist to produce a patterned resist substrate composite.

Among the substrates which can be treated in accordance with the practice of the method of the present invention to make resist-substrate composites are copper clad laminates, silicon wafers, silicon dioxide wafers, aluminum and gallium arsenide.

Some of the developers which can be used in the practice of the method of the invention are aqueous base solutions, e.g. aqueous solutions of NaOH, KOH, and tetrabutylammonium hydroxide. Typical developers are made by Shipley Company of Newton, Massachusetts, Hunt Company of East Providence, Rhode Island, amd KTI Company of Wallingford, Connecticut.

It has been further found that the afore-described onium salts or initiators can be used in combination with various photosensitizers to enhance the absorption of a given wavelength of light or sensitize the onium salt to a region of a spectrum where it does not absorb. Typical sensitizers which can be used in combination with the afore-described initiators or mixtures thereof are, for example: benzophenone, 2-chlorothioxanthone, anthrone, 9-ethoxyanthracene, anthracene, pyrene, perylene, phenothiazine, benzil, acridine orange, benzoflavin, setoflavin-T, anthraquinone, 9,10-diphenylanthracene, 9-fluorenone, benzophenone, and coronene.

The above-described sensitizers also can be used in combination with the initiators utilized in the practice of the present invention to modify the response of the photoresist under electron beam and X-ray irradiation as well as visible or UV irradiation.

Some of the resist applications contemplated for the resist compositions of the present invention are, for example, manufacture of circuit boards, integrated circuits, multilayer resist structures, e.g. in combination with polymethylmethacrylate, and the like. There also can be used in the resist composition of the present invention, flow control agents, surface active agents, anti-reflection dyes and wetting agents.

In order that those skilled in the art will be better able to practice the present invention, the following examples are given by way of illustration and not by way of limitation. All parts are by weight.

### EXAMPLE 1

Photoresist compositions were prepared utilizing 1.5 g of various commercially available phenolic resins having a molecular weight of about 1000, 0.5 g of di-t-butylterephthalate, 0.1 g of diphenyl-4-thiophenoxyphenylsulfonium hexafluorophosphate, and 6 mL of 1-methoxy-2-propyl acetate. The various photoresist compositions were spin coated onto silicon wafers which had been previously treated with hexamethyldisilazane. The treated wafers were then baked for 1/2 hour at 90°C. The wafers were then exposed to imagewise irradiation using a Suss MA 56 Contact/Proximity Printer operated in the proximity mode at 313 nm, using an exposure time of 10-40 seconds with an intensity of 4.5 mW/cm². After exposure, the wafers were heated in a forced air oven for a period of 60 seconds at 110-130°C and then developed using a mixture of water and KTI 351 Developer. The following lists the commercially available resins utilized "Phenolic resin" along with the development mixture and type of development:

| Phenolic Resin | Dev/Water |
|---|---|
| meta-cresol novolac | 1:1 |
| polyvinylphenol | 5:1 (immersion) |
| t-butylphenol novolac | 5:1 (immersion) |

The resists were developed and 2 to 3.5 um features were resolved.

### EXAMPLE 2

Inhibitor, t-butylnaphthalene-2-carboxylate was prepared as follows:

A mixture of 51.6 g (0.3 mole) of 2-naphthoic acid, and 120 ml of thionylchloride was refluxed for one hour. Excess thionylchloride was removed. The resulting solid was dissolved in 150 mL of tetrahydrofurane and 40 grams (0.35 mole) of potassium t-butoxide was added in increments. After the addition had been completed, the reaction mixture was refluxed for four hours, cooled, and then poured into water. The resulting solid was collected by filtration, washed with water and dried in vacuo. The product was recrystallised from n-hexane to produce a crystalline solid having a melting point of 88-90°C. Based on method of preparation, the product was t-butyl-naphthalene-2-carboxylate which was obtained in a yield of 68%.

A photoresist composition was prepared in accordance with the procedure of Example 1, utilizing 1.5 g of meta cresol novolac resin, 0.5 g of t-butyl naphthalene-2-carboxylate, 0.1 g of diphenyl-4-thiophenoxyphenylsulfonium hexafluorophosphate, and 6 mL of 1-methoxy-2-propyl acetate. Coated silicon wafers prepared in accordance with the procedure of Example 1 provided excellent positive images with well resolved 3.5 micrometers features after imagewise exposure to UV light utilizing a 15-40 second irradiation time.

### EXAMPLE 3

Additional photoresist compositions were prepared utilizing commercially available meta cresol novolac resin with di-t-butylterephthalate or t-butylnaphthalene-2-carboxylate. In preparing the photoresist using di-t-butylterephthalate dissolution inhibitor, there were utilized 1.5 g of meta cresol novolac resin, 0.5 g of inhibitor, 0.1 g of 4-methoxyphenylphenyliodonium trifluoromethylsulfonate, and 0.03 g of 9-fluorenone, a photosensitizer.

The photoresist utilizing t-butylnaphthalene-2-carboxylate was combined with 1.5 g of the meta cresol novolac resin, 0.5 g of the inhibitor, 0.1 g 4-methoxyphenylphenyliodonium trifluoromethylsulfonate, 0.01 g of perylene photosensitizer, and 6 mL of 1-methoxy-2-propyl acetate.

The above photoresist compositions were then spin coated onto siicon wafers in accordance with the procedure of Example 1. A photoresist composition containing the di-t-butylterephthalate inhibitor and the 9-fluorenone photosensitizer was irradiated for five seconds at 313 nm, while the photoresist composition containing the t-butylnaphthalene-2-carboxylate and the perylene sensitizer was irradiated for 5 seconds at 365 nm (6.3 mW/cm²) and 405-436 nm (8.1 mW/cm²). The following Table combines the inhibitors, photosensitizers and wave lengths which were used:

| Inhibitor | Photosensitizer | UVλ(nm) |
|---|---|---|
| di-t-butyl terephthalate | 9-fluorenone | 313 |
| t-butylnaphthalene-2-carboxylate | perylene | 405-436 365 |

The resists were processed in KTI 350 developer under the conditions described above, and 1 µm features were resolved.

### EXAMPLE 4

Inhibitor t-butyl-2-naphthyl carbonate was prepared by the following procedure:

There were added 3.9 g (0.035 mole) of potassium-t-butoxide to a solution of 5 g (0.35 mole) of 2-naphthol in 90 mL of tetrahydrofuran under a nitrogen atmosphere. The mixture was stirred for 5 minutes and 8.3 g (0.035 mole) of di-t-butyldicarbonate was added. The mixture was stirred for 2 hours. The mixture was then poured into ice water and extracted twice with ethylacetate. The combined organic layers were washed three times with water followed by a saturated sodium chloride solution and then dried over anhydrous sodium sulfate. The mixture was then concentrated using a rotary evaporator. A crystalline solid was obtained and recrystallized from petroleum ether and then dried in vacuo. There was obtained 65% yield of t-butylnaphthyl carbonate having a melting point of 74-75°C.

A photoresist composition was prepared following the procedure of Example 1 utilizing 1.2 g of commercially available meta cresol novolac resin, 0.8 g of t-butyl-2-naphthylcarbonate, 0.1 g of diphenyl-4-thiophenoxyphenylsulfoniumhexafluorophosphate and 6 mL of 1-methoxy-2-propylacetate. Wafers were spin coated and exposed for 20-40 seconds as described in Example 1 and baked at 125°C for 30-60 seconds. There were obtained clear 2 micrometer lines and spaces after the photoresist was developed for one minute in a 1:2.5 mixture of KTI 351 and water.

### EXAMPLE 5

A photoresist composition was prepared in accordance with the procedure of Example 1 utilizing 1.2 g m-cresol novolac resin, 0.8 g 4-t-butoxy-p-biphenyl, 0.1 g diphenyl-4-thiophenoxy-1-phenyl sulfonium hexafluorophosphate and 6 mL 1-methoxy-2-propyl acetate. Cleared 3 um lines and spaces were obtained by exposing coated wafers to 313 nm UV for 20-40 seconds, a 30-60 second bake at 125°C and immersion in a 1:1 solution of KTI351 and water.

### EXAMPLE 6

A photoresist composition was prepared utilizing 1.5 g of commercially available meta cresol novolac resin, 500 mg of t-butyl-1H-indene-3-carboxylate, 100 mg of diphenyl-4-thiophenoxyphenylsulfonium hexafluorophosphate and 6 mL of 1-methoxy-2-propylacetate. The photoresist was spin coated and irradiated as described in Example 1. There was obtained clear 2.5 micron lines and spaces with irradiation at 313 nm for 15-20 seconds, a 30-60 second bake at 125°C and a development for one minute in a 1:1 solution of KTI 351 developer and water.

### EXAMPLE 7

Photoresist compositions were prepared utilizing commercially available meta cresol novolac, t-butyladamantane-1-carboxylate, and various initiators and 1-methoxy-2-propylacetate. One of the photoresist compositions was made by blending together 1.5 g meta cresol novolac, 500 mg of t-butyladamantane-1-carboxylate, 100 mg of diphenyl-4-thiophenoxyphenylsulfonium hexafluorophosphate and 6 mL of 1methoxy-2-propylacetate. Another photoresist formulation utilized 1.5 g of the meta cresol novolac resin, 500 mg of the inhibitor, 110 mg of 4-methoxyphenyl-iodonium-hexafluorophosphate, and 6 mL of 1-methoxy-2-propylacetate. The various photoresist compositions were applied to silicon wafers as previously described and subjected to imagewise exposure at 313 nm for 10-15 seconds and at 254 nm for 2-3 sec at 5.22 mW/cm². The resists were processed in accordance with the procedure of Example 1. There were resolved 3 um features from the sulfonium containing photoresist and 2.5 micron features from the iodonium containing photoresist.

### EXAMPLE 8

A photoresist composition consisting of 1.5 g m-cresol novolac resin (Schenectady Chemicals HRJ 2606), 500 mg di-t-butyladipate, 100 mg 4-methoxyphenylphenyliodonium hexafluorophosphate and 6 mL 1-methoxy-2-propyl acetate was spin coated onto silicon wafers which had been previously treated with hexamethyldisilazane and baked. A film coating of 2 micrometers was obtained. The photoresist coatings were exposed for 4-5 seconds using a Suss MA56 Contact/Proximity Printer operated in the proximity mode at 254 nm with an intensity of 5.22 mW/cm². After exposure, the wafers were postbaked for 30-60 seconds at 130°C, then developed for 60 seconds in a 1:1 mixture of KTI 351 and water. Cleared well-imaged patterns were obtained having 3.5 um lines and spaces.

### EXAMPLE 9

There was dissolved 3 g of the m-cresol novolac resin of Example 8 in 10 mL methyl ethyl ketone. There was added to the resulting solution, 1 g t-butyl-2-naphthalene carboxylate, 0.02 g perylene and 0.2 g 4-methoxyphenylphenyliodonium trifluoromethanesulfonate. The mixture was coated onto a copper-clad epoxy-glass circuit board and dried to remove the solvent. The dried circuit board was covered with a Mylar resin photographic negative. A GE H-3T7 medium pressure mercury arc lamp ballasted at 800 W was used to irradiate the negative for 30 seconds at a distance of 8 inches. Following imaging. the circuit board was baked for 3 minutes at 100°C and then developed in a 1:1 mixture of KTI 351 and water. The pattern was then etched into the circuit board using an aqueous ferric chloride solution giving a clear chloride solution giving a clear positive image of the mask.

Although the above results are directed to only a few of the very many variables which can be utilized in the practice of the present invention, it should be understood that the present invention is directed to the use of a much broader variety of polymers, inhibitor, and initiators, in the description preceding these examples.

## Claims

1. A resist composition comprising by weight
(A) 100 parts of organic solvent, and
(B) from 5 to 85 parts of solids admixed with (A) comprising by weight
(1) 100 parts of a water or aqueous base soluble organic polymer having an average MW of from 200 to 20,000;
(2) 5 to 100 parts of an acid labile group substituted simple compound which is a dissolution inhibitor for (1), which is insoluble in water or aqueous base, has a boiling point of at least 100°C, and is selected from tertiary butyl esters, aryl tertiary butyl ethers, aryl tertiary butyl carbonates, 3-cyclohexenyl benzoate, and 3,6-bis(benzoyloxy)cyclohexene, and
(3) an effective amount of an aryl onium salt.

2. A spinnable or solution castable composition in accordance with Claim 1, where the organic polymer is a novolak resin.

3. A spinnable or solution castable composition in accordance with Claim 1, where the aryl onium salt is a sulfonium salt.

4. A spinnable or solution castable composition in accordance with Claim 1, where the aryl onium salt is an iodonium salt.

5. A spinnable or solution castable composition in accordance with Claim 1 containing a photosensitizer.

6. A spinnable or solution castable composition in accordance with Claim 1, where the onium salt is triphenylsulfonium hexafluoroantimonate.

7. A spinnable or solution castable composition in accordance with Claim 1, where the onium salt is diphenyl-4-thiophenoxyphenylsulfonium hexafluorophosphate.

8. A spinnable or solution castable composition in accordance with Claim 1, where the onium salt is 4-methoxyphenylphenyliodonium hexafluorophosphate.

9. A spinnable or solution castable composition in accordance with Claim 1, where the onium salt is 4-methoxyphenylphenyliodonium trifluoromethane sulfonate.

10. A method for making a patterned resist substrate composite which comprises
(1) treating a substrate with the resist composition of Claim 1 to produce a resist-substrate composite,
(2) baking the resist-substrate composite to a temperature in the range of from about 35°C to 180°C,
(3) irradiating the applied resist in a patterned manner,
(4) heating the irradiated resist to a temperature in the range of from about 35°C to 185°C, and
(5) developing the irradiated resist to produce a patterned resist substrate composite.

11. A composite comprising a substrate and a resist composition made in accordance with the method of Claim 10.

12. A composite in accordance with Claim 11, where the substrate is a silicon wafer.

13. A composite in accordance with Claim 11, where the substrate is a copper-clad laminate.

## Patentansprüche

1. Resistzusammensetzung, die gewichtsmäßig besteht aus
(A) 100 Teilen eines organischen Lösemittels, und
(B) 5 bis 85 Teilen von Feststoffen, welche (A) beigemischt sind und gewichtsmäßig bestehen aus
(1) 100 Teilen eines wasserlöslichen oder auf einer wässrigen Basis löslichen organischen Polymers mit einem mittleren Molekulargewicht von 200 bis 20.000;
(2) 5 bis 100 Teilen einer mit einer säurelabilen Gruppe substituierten einfachen Verbindung, welche ein Lösungsinhibitor für (1) ist, welche in Wasser oder der wässrigen Basis unlöslich ist, einen Siedepunkt von wenigstens 100°C hat und ausgewählt ist unter den tertiären Butylestern, Aryl-tertiären Butylethern, Aryl-tertiären Butylcarbonaten, 3-Cyclohexenylbenzoat und 3,6-bis(Benzoyloxy)Cyclohexen, und
(3) einer wirksamen Menge eines Aryl-Onium-Salzes.

2. Spinnfähige oder als Lösung gießfähige Zusammensetzung nach Anspruch 1, bei welcher das organische Polymer ein Novolak-Harz ist.

3. Spinnfähige oder als Lösung gießfähige Zusammensetzung nach Anspruch 1, bei welcher das Aryl-Onium-Salz ein Sulfoniumsalz ist.

4. Spinnfähige oder als Lösung gießfähige Zusammensetzung nach Anspruch 1, bei welcher das Aryl-Onium-Salz ein Iodoniumsalz ist.

5. Spinnfähige oder als Lösung gießfähige Zusammensetzung nach Anspruch 1, welche einen Photosensibilisator enthält.

6. Spinnfähige oder als Lösung gießfähige Zusammensetzung nach Anspruch 1, bei welcher das Oniumsalz Triphenylsulfonium-Hexafluorantimonat ist.

7. Spinnfähige oder als Lösung gießfähige Zusammensetzung nach Anspruch 1, bei welcher das Oniumsalz Diphenyl-4-Thiophenoxyphenylsulfonium-Hexafluorphosphat ist.

8. Spinnfähige oder als Lösung gießfähige Zusammensetzung nach Anspruch 1, bei welcher das Oniumsalz 4-Methoxyphenylphenyliodonium-Hexafluorphosphat ist.

9. Spinnfähige oder als Lösung gießfähige Zusammensetzung nach Anspruch 1, bei welcher das Oniumsalz 4-Methoxyphenylphenyliodonium-Trifluormethan-Sulfonat ist.

10. Verfahren zum Herstellen eines bemusterten Resistsubstrat-Komposits, bestehend aus
(1) der Behandlung eines Substrats mit einer Resistzusammensetzung nach Anspruch 1 zur Herstellung eines Resistsubstrat-Komposits,
(2) einem Brennen des Resistsubstrat-Komposits auf eine Temperatur in dem Bereich von etwa 35°C bis 180°C,
(3) einem Bestrahlen des aufgebrachten Resists gemäß einem Muster,
(4) einer Erhitzung des bestrahlten Resists auf eine Temperatur in dem Bereich von etwa 35°C bis 185°C, und
(5) einem Entwickeln des bestrahlten Resists zur Herstellung eines bemusterten Resistsubstrat-Komposits.

11. Komposit, welches aus einem Substrat und einer Resistzusammensetzung besteht, hergestellt nach dem Verfahren gemäß Anspruch 10.

12. Komposit nach Anspruch 11, bei welchem das Substrat ein Siliziumwafer ist.

13. Komposit nach Anspruch 11, bei welchem das Substrat ein mit Kupfer plattiertes Laminat ist.

## Revendications

1. Composition de réserve comprenant, en poids
(A) 100 parties de solvant organique, et
(B) de 5 à 85 parties de solides mélangés à (A) comprenant, en poids
(1) 100 parties d'un polymère organique soluble dans l'eau ou une base aqueuse ayant un PM moyen de 200 à 20 000;
(2) de 5 à 100 parties d'un composé simple substitué par un groupe labile aux acides qui est un inhibiteur de dissolution pour (1), qui est insoluble dans l'eau ou les bases aqueuses, a un point d'ébullition dd'au moins 100°C, et est choisi parmi les esters de butyle tertiaire, les éthers d'aryl-butyle tertiaire, les carbonates d'aryl-butyle tertiaire, le benzoate de 3-cyclohexényle et le 3,6-bis(benzoyloxy)cyclohexane, et (3) une quantité efficace d'un sel d'aryl-onium.

2. Composition filable ou coulable en solution selon la revendication 1, dans laquelle le polymère organique est une résine novolaque.

3. Composition filable ou coulable en solution selon la revendication 1, dans laquelle le sel dd'arylonium est un sel de sulfonium.

4. Composition filable ou coulable en solution selon la revendication 1, dans laquelle le sel d'aryl-onium est un sel d'iodonium.

5. Composition filable ou coulable en solution selon la revendication 1 contenant un photosensibilisateur.

6. Composition filable ou coulable en solution selon la revendication 1, dans laquelle le sel d'onium est l'hexafluoroantimonate de triphénylsulfonium.

7. Composition filable ou coulable en solution selon la revendication 1, dans laquelle le sel d'onium est l'hexafluorophosphate de diphényl-4-thiophénoxyphénylsulfonium.

8. Composition filable ou coulable en solution selon la revendication 1, dans laquelle le sel d'onium est l'hexafluorophosphate de 4-méthoxyphénylphényliodonium.

9. Composition filable ou coulable en solution selon la revendication 1, dans laquelle le sel d'onium est le trifluorométhanesulfonate de 4-méthoxyphénylphényliodonium.

10. Procédé de préparation d'un composite substrat de réserve à motif, dans lequel
(1) on traite un substrat avec la composition de réserve de la revendication 1 pour produire un composite réserve-substrat,
(2) on fait cuire le composite réserve-substrat à une température allant d'environ 35°C à 180°C,
(3) on irradie la réserve appliquée en suivant un motif,
(4) on chauffe la réserve irradiée à une température allant d'environ 35°C à 185°C, et
(5) on développe la réserve iradiée pour produire un composite substrat de réserve avec motif.

11. Composite comprenant un substrat et une composition de réserve préparée selon le procédé de la revendication 10.

12. Composite selon la revendication 11 dans lequel le substrat est une plaquette de silicium.

13. Composite selon la revendication 11 dans lequel le substrat est un stratifié plaqué de cuivre.
